Europäisches Patentamt

European Patent Office

Office européen des brevets

(19)

(11) Publication number: **0 281 781 B1**

## EUROPEAN PATENT SPECIFICATION

(12)

(45) Date of publication of patent specification: **12.08.92**

(51) Int. Cl.5: **H01P 5/04**

(21) Application number: **88101981.4**

(22) Date of filing: **11.02.88**

(54) **Lower-noise microwave amplifying circuit.**

(30) Priority: **13.02.87 JP 32112/87**

(43) Date of publication of application:
**14.09.88 Bulletin 88/37**

(45) Publication of the grant of the patent:
**12.08.92 Bulletin 92/33**

(84) Designated Contracting States:
**DE FR GB**

(56) References cited:
**EP-A- 0 154 496**
**US-A- 3 638 148**
**US-A- 3 796 976**

(73) Proprietor: **SHARP KABUSHIKI KAISHA**
**22-22 Nagaike-cho Abeno-ku**
**Osaka 545(JP)**

(72) Inventor: **Nakamura, Makio**
**1-4, Sekime 2-chome Joto-ku**
**Osaka-shi Osaka-fu(JP)**

(74) Representative: **Selting, Günther, Dipl.-Ing. et**
**al**
**Patentanwälte von Kreisler, Selting, Werner**
**Deichmannhaus am Hauptbahnhof**
**W-5000 Köln 1(DE)**

# Description

The present invention relates to a low-noise microwave amplifying circuit which is used for a low-noise converter for satellite broadcast reception use, and, more particularly, to a low-noise microwave amplifying circuit which is easily adjusted in the basic performance of input VSWR (i.e., voltage standing-wave-ratio) or the like and is simple in construction.

A conventional microwave amplifying circuit for use in such a converter is generally constructed as shown in Fig. 5. Fig. 5 shows a top-plane view of the essential portions in the conventional example.

Referring to Fig. 5, in order to adjust the basic performance of the input VSWR or the like, island-shaped patterns 3, 3, ... are provided near the connecting portion between the coaxial input rod of the waveguide-to-coaxial conversion portion and the microstrip line 2 to connect them properly with the microstrip circuit by soldering or the like for the adjusting operation. A semiconductor circuit element 4 is composed of GaAs field effect transistors (FET) or the like.

The island-shaped patterns 3, 3, ... provided as described hereinabove have the following disadvantages.

(1) Much time and labor are required to make adjustment, because the respective island-shaped patterns 3, 3, ... must be soldered for the adjustment,

(2) Solder removing operation is very difficult to perform,

(3) There is a risk of electrostatically breaking the semiconductor circuit elements 4 such as GaAs FET, etc. in the adjustment,

(4) Fine adjustments are difficult to make, because island-shaped patterns 3,3, ... are restricted in size, and

(5) The adjustment of the input VSWR is affected and also, the noise figure and the gain characteristics determining the respective characteristics are influenced.

US-A-3 638 148 discloses a converter for coupling a waveguide to a microstrip circuit. A coaxial rod extending into a coaxial-to-microstrip conversion portion extends through a base plate 7 bearing the microstrip circuit. The coaxial rod further extends through a capacity matching disc having a microstrip circuit conductor overlap projection, and projects beyond the capacity matching disc. The microstrip circuit conductor overlap projection is carefully sized for providing proper capacity impedance match in the coaxial-to-microstrip circuitry transition. With such a construction, a trimming operation is not possible because the capacity matching disc is prefabricated.

Accordingly, an object of the present invention is to provide a lower-noise microwave amplifying circuit which can be readily adjusted and is simple in construction.

This object is solved, according to the invention, with the features of the claim.

The flexible metallic conductor for adjustment use may be a linear rod member made of tin-plated line or the like which is approximately 0.5 mm in diameter and is one fourth or less in length of the working frequency wavelength.

The metallic conductor projecting from the microstrip line near the connecting portion, is properly bent to fixedly retain the shape, and is provided near the connecting portion between the coaxial rod of the waveguide-to-coaxial conversion portion and a microstrip line which is one portion of the amplifying circuit, so that the admittance in the connecting portion may be adjusted through the variation in the height (or the distance) from the microstrip line. The fine adjustment of the admittance may be readily effected by the bending degree.

The basic performance of the input VSWR or the like may be readily adjusted by the adjustment of the admittance by bending the metallic conductor as described hereinabove.

These and other objects and features of the present invention will become apparent from the following description taken in conjunction with a preferred embodiment thereof with reference to the accompanying drawings, in which;

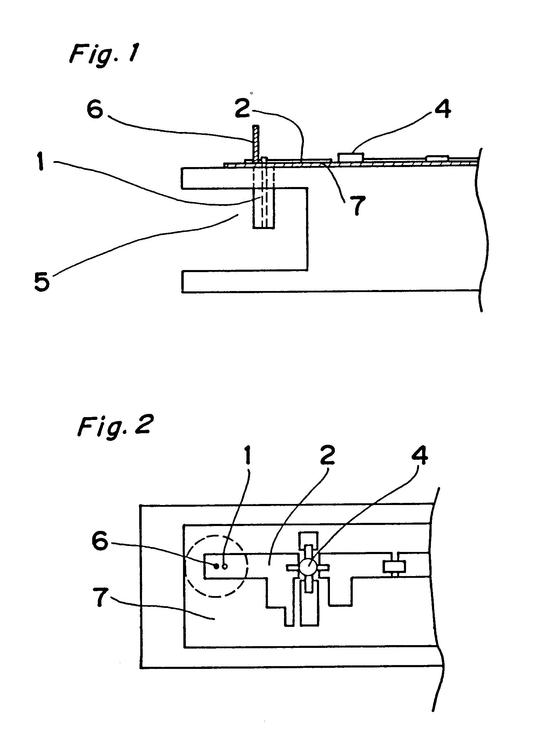

Fig. 1 is side elevational view showing a waveguide-to-coaxial converting portion of a microwave amplifying circuit in accordance with one embodiment of the present invention;

Fig. 2 is a top plane view of the portion of Fig. 1;

Fig. 3 is the side elevational view, on an enlarged scale, of a portion of Fig. 1;

Fig. 4(A), (B) are characteristic graphs each showing the measured data example of the input VSWR by the adjustments A, B of Fig. 3; and

Fig. 5 is top plane view similar to Fig. 1, but showing the conventional example as already referred above.

A flexible metallic conductor 6 is provided in a connecting portion between a Teflon sheathed coaxial rod 1 in a waveguide-to-coaxial converting portion 5 and a microstrip line 2 of the amplifying circuit. This is performed by the soldering operation of the metallic conductor 6 onto the microstrip line 2 simultaneously with the soldering operation of the coaxial rod 1.

The metallic conductor 6 uses a linear material such as tin-plated line or the like, which has better soldering properties, and is easier to bend securely. The linear material is preferably approximately 0.5 mm thick in diameter and has a length of one fourth or less (approximately 4 mm or less in the case of a working frequency of approximately 12 GHz on a Teflon base plate 7 having, a dielectric constant of 2.6 of the working frequency wavelength on the microstrip line, so as to prevent resonance in the working frequency and its vicinity.

In order to effect the adjusting operation, the metallic conductor 6 secured to the connecting portion is bent downwardly or erected on the microstrip line 2 near the connecting portion.

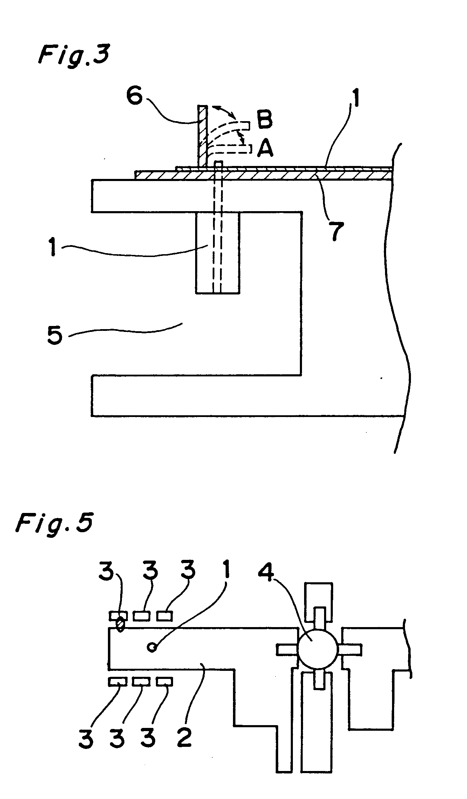

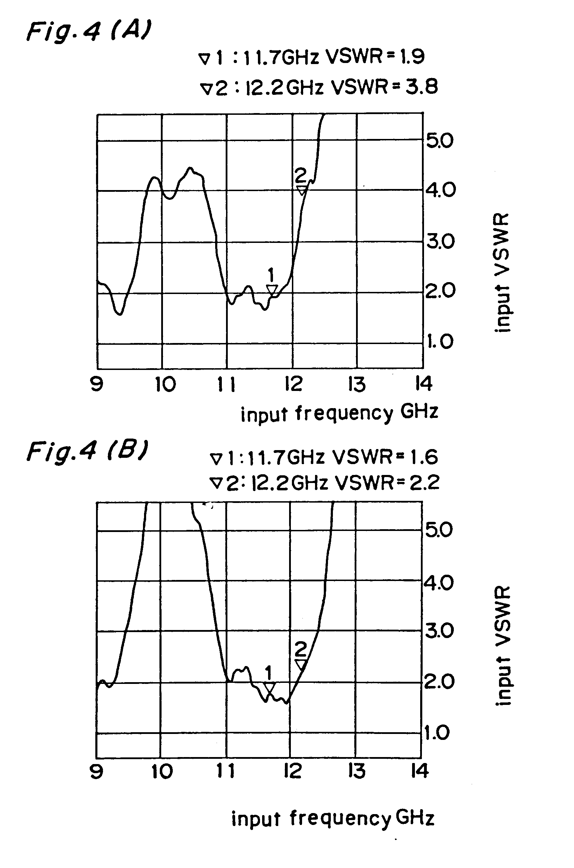

Assume that the metallic conductor 6 has been bent as shown by reference characters A, B of Fig. 3. Fig. 4 (A) shows the measured data example of the input VSWR when the metallic conductor has been bent as the reference character A shows, while Fig. 4 (B) shows the measured data of the input VSWR when the metallic conductor has been bent as the reference character B shows. In Fig. 4 (A), the input VSWR is 1.9 when the input frequency is 11.7 GHz, the input VSWR is 3.8 when the input frequency GHz is 3.8. In Fig. 4 (B), the input VSWR is 1.6 when the input frequency is 11.7 GHz, the input VSWR is 2.2 when the input frequency is 12.2 GHz.

As apparent from the comparison between Fig. 4 (A), (B), Fig. 4 (B) is more preferable at the input VSWR in the working frequency 12 GHz and its vicinity. It is found out that the metallic conductor 6 is required to be bent in the adjustment as shown by the reference character B of Fig. 3.

Also, as the case may be, the metallic conductor 6 may be cut with a nipper or the like to change the length thereof. This is useful especially when the considerable adjustment is required.

The adjustment is easier to make, because the metallic conductor 6 may be bent or erected through a light pushing operation with an insulating pincette, an adjusting rod or the like in the input VSWR adjustment. As the fine adjustment is easier to make, the adjustment may be made to an input VSWR value which is considered to be optimum, considering the relation with respect to another basic performance (for example, with respect to noise).

The metallic conductor 6 is on the microstrip line 2 near the connecting portion and the height (or distance) from the microstrip line 2 is varied to make the adjustment, so that an effect is given onto only the admittance of the connecting portion between the input Teflon coaxial rod in the coaxial waveguide portion 5 and the microstrip line 2, thus resulting in less influence upon the pattern on the microstrip line 2 and less bad-influence upon the other basic capability (for example, noise figure or gain).

As there is no risk of electrostatically breaking the semiconductor circuit element 4 such as GaAs FET or the like or breaking it through the short-circuiting by the use of an insulating regulating rod or a pincette, the adjusting may be effected during energizing.

In the above-described embodiment, a tin-plated line is used for the metallic conductor 6, which is not the only way. Also, the rod shape need not be made linear, but also square or flat.

For example, a copper plate may be used though it is somewhat expensive. In addition to the soldering method, various methods may be adopted to secure the metallic conductor 6. As the metallic conductor 6, the core material of the input Teflon coaxial rod 2 may be projected from on the microstrip line 2. This may be properly bent to serve for the metallic conductor 6 in the present embodiment.

As is clear from the foregoing description, according to the arrangement of the present invention, a lower-noise microwave amplifying circuit may be provided, which is simpler in construction, may be easily adjusted in the basic performance of the input VSWR or the like, and is higher in practical value.

## Claims

1. A low noise amplifier comprising a waveguide input section (5), a waveguide-to-coaxial conversion portion (5,1), a coaxial-to-microstrip conversion portion (1,2) and a microstrip circuit;

   said waveguide-to-coaxial conversion portion (5,1) comprising a first end of a coaxial rod (1) which projects into the waveguide input section (5);

   said coaxial-to-microstrip conversion portion (1,2) comprising the second end of said coaxial rod (1) which passes through the ground plane of said microstrip circuit and is soldered to the microstrip (2) at the input of said microstrip circuit;

   **characterized in that**

   an elongated metallic conductor (6) is soldered to said microstrip (2) near to the connection with the coaxial rod (1) and projects out of the plane of said microstrip (2); and

   the shape of said metallic conductor (6) is adjusted by bending or shortening to adjust the performance of the coaxial-to-microstrip conversion portion (1,2).

2. The low noise amplifier of claim 1, wherein the metallic conductor (6) is formed of a linear line that is tin-plated.

## Revendications

1. Amplificateur à faible bruit comprenant une section d'entrée de guide d'ondes (5), une partie de conversion guide d'ondes - coaxiale (5, 1), une partie de conversion coaxiale - microbande (1, 2) et un circuit microbande ;

ladite partie de conversion guide d'ondes - coaxiale (5, 1) comprenant une première extrémité d'une tige coaxiale (1) qui se prolonge dans la section d'entrée de guide d'ondes (5);

ladite partie de conversion coaxiale - microbande (1, 2) comprenant la seconde extrémité de ladite tige coaxiale (1) qui passe à travers le plan de mise à la masse dudit circuit microbande et qui est soudée à la microbande (2) à l'entrée dudit circuit microbande ;

caractérisé en ce qu'un conducteur métallique de forme allongée (6) est soudé sur ladite microbande (2) près de la connexion avec la tige coaxiale (1) et se prolonge au-delà du plan de ladite microbande (2) ; et en ce que la forme dudit conducteur métallique (6) est ajustée par cintrage ou raccourcissement, dans le but de régler le rendement de la partie de conversion coaxiale - microbande (1, 2).

2. Amplificateur à faible bruit selon la revendication 1, dans lequel le conducteur métallique (6) est formé d'une barre droite qui est étamée.

**Patentansprüche**

1. Rauscharmer Verstärker mit einem Wellenleitereingangsabschnitt (5), einem Wellenleiter-Koaxial-Wandelbereich (5, 1), einem Koaxial-Mikrostreifen-Wandel-bereich (1, 2) und einer Mikrostreifenschaltung;
wobei der Wellenleiter-Koaxial-Wandelbereich (5, 1) ein erstes Ende eines koaxialen Stabs (1) aufweist, das in den Wellenleitereingangsabschnitt (5) ragt;
wobei der Koaxial-Mikrostreifen-Wandelbereich (1, 2) das zweite Ende des koaxialen Stabs (1) aufweist, das sich durch die Grundebene der Mikrostreifenschaltung erstreckt und am Eingang der Mikrostreifenschaltung an den Mikrostreifen (2) angelötet ist;
dadurch gekennzeichnet, daß
ein langgestreckter metallischer Leiter (6) nahe der Verbindung mit dem koaxialen Stab (1) an den Mikrostreifen (2) gelötet ist und aus der Ebene des Mikrostreifens (2) hervorsteht; und die Form des metallischen Leiters (6) durch Biegen oder Verkürzen angepaßt wird, um das Verhalten des Koaxial-Mikrostreifen-Wandelbereichs (1, 2) einzustellen.

2. Rauscharmer Verstärker nach Anspruch 1, bei dem der metallische Leiter (6) aus einer zinnbeschichteten linearen Leitung besteht.

*Fig. 1*

*Fig. 2*

**Fig.3**

**Fig.5**

*Fig. 4 (A)*

▽1 : 11.7GHz VSWR = 1.9

▽2 : 12.2GHz VSWR = 3.8

input VSWR

input frequency GHz

*Fig. 4 (B)*

▽1 : 11.7GHz VSWR = 1.6

▽2 : 12.2GHz VSWR = 2.2

input VSWR

input frequency GHz